# EUROPEAN PATENT SPECIFICATION

(11) **EP 0 325 798 B1**
(45) Date of publication and mention of the grant of the patent: **08.09.1993**
(21) Application number: 88121809.3
(22) Date of filing: 28.12.1988
(51) Int. Cl.: B22F 9/08, B22F 1/00, B23K 35/02

(54) **A metallic powder and a paste made from it, and a metallic powder manufacture device**
Metallpulver, dieses Pulver enthaltende Paste und Vorrichtung zur Herstellung dieses Pulvers
Poudre métallique, pâte préparée à partir de cette poudre et installation pour la préparation de cette poudre

(30) Priority: 14.01.1988 JP 4837/88; 04.04.1988 JP 82717/88
(43) Date of publication of application: 02.08.1989
(73) Proprietor: Electroplating Engineers of Japan Limited, Nihonbashi Chuo-ku Tokyo 103 (JP)
(72) Inventor: Kitada, Katsutsugu, Hiratsuka-shi Kanagawa-ken (JP)
(74) Representative: Bühling, Gerhard, Dipl.-Chem.

(56) References cited:
- WO-A-84/01729
- WO-A-86/03700
- DE-A- 3 109 909
- US-A- 2 811 748
- US-A- 4 380 518
- US-A- 4 711 660

## Description

The present invention concerns a metallic powder and a paste made from it, as well as a metallic powder manufacture device; more specifically a technique for the manufacture of "solder" powder ideally suited for use as a "solder paste", through the extrusion, from multiple microscopic nozzle holes, of molten metal, which while falling and cooling changes shape from a droplet to a spherical shape and then solidifies.

Powders and pastes (called powders/pastes below) obtained through the use of techniques such as the atomization method, the rolling method, the solubility method, and the reduction/mixing method have been known in prior art. However, each of these techniques had advantages and disadvantages: the atomization method gave a bad yield in powder production because the powder thus produced contained a dust-like substance called "fine", while the rolling method or the solubility method could not produce powders with particles of a small enough size and were unsuitable for mass-production, while the reduction/mixing method produced a powder too fine and not suitable as solder. Powder manufacture using a nozzle method had also been previously considered, but because the powder produced had a large particle size.

US 4,380,518 discloses a method for producing solder spheres having non-oxidized surfaces by introducing solder into a flux composition comprising an activator and an antioxidant. Molten solder is extruded into the flux composition maintained at ambient temperature or a solder powder is sifted into hot flux and then cooled. This known method generates particles which have a size of 100 µm up to 2 mm; furthermore, the molten solder is directly extruded into the flux composition.

WO 84/01729 decribes a method and an apparatus for the continuous processing of molten metal by passing a molten metal through a trough having a perforated bottom to form streams of droplets, passing the droplets through a counter current flow of circulating inert cooling gas medium to produce solidified granules.

Us 4,711,660 describes a process for producing a powdered material. The powdered material consists essentially of spherical particles and is essentially free of elliptically shaped material and elongated material having rounded ends.

As the density of surface mounting of chips on printed circuit boards has increased, the gaps between the patterns on the printed circuit boards have been reduced. Consequently, the powders or pastes used to surface mount these chips on the printed circuit board must satisfy certain conditions, not to mention improved flux, such as they must be sufficiently small in size, have good granularity, no fine, and no "dulling" after printing or painting. However, none of the powders or pastes made using former methods were able to satisfy these requirements

Further, a number of methods such as the atomization method and the nozzle method have been known in prior art as techniques for manufacturing powder. However, the resulting "solder" powder was inadequate for use in "solder paste". A description of a nozzle method of prior art is described in Japanese Patent Publication No. 44361/1984.

Previously, using normal nozzle techniques, it was difficult to obtain particles of a size appropriate for "solder paste" ie less than 90 µm in diameter. The nozzle technique revealed in the said Japanese Patent Publication No. 44361/1984 has the same problems as the atomization method described below.

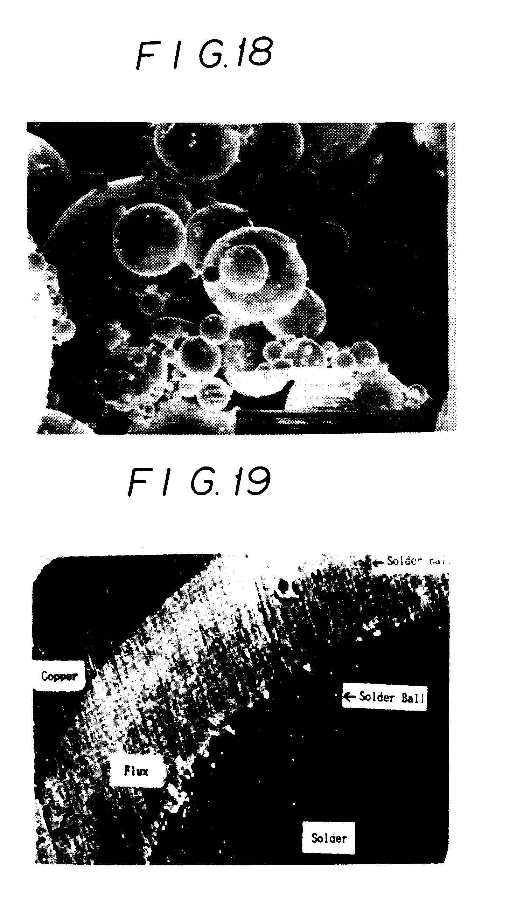

As a general rule, the atomization method always had too wide a rosin-rammer distribution (R-R distribution) of microscopic particles, and extremely minute particles of a dust-like substance called "fine" occurred frequently. This "fine" was impossible to sieve out even with a sieve, because some of it was physically attached to the standard-sized particles, and thus the "solder powder" as a product was always mixed in with this "fine". As a result, when "solder paste" made with this "solder powder" was applied to a printed circuit board, for example, there was always the danger that because of the relatively large surface area, the "fine" part would oxidize easily, becoming "solder balls" and resulting in a defective product. Fig. 18 shows a photograph of the microscopic particles including "fine", where the particles of extremely small diameter are physically attached to the standard-sized particles (powder). Fig. 19 shows a photograph of one example of a solder ball.

This invention presents a metallic powder according to claim 1 which satisfies the above conditions of being of sufficiently small size, having no fine, and not "dulling" after printing or painting; and a device for manufacturing this powder according to claim 6 and a process for producing the metallic powder according to claim 12. The metallic powder and paste of this invention is a metallic powder obtainable by extrusion of molten metal from multiple microscopic nozzle holes in an inert gas atmosphere, the metal cooling as it falls, and during that time changing from a droplet shape to a spherical shape and solidifying, said metallic powder having non-curved sections in parts of the generally curved surface forming the sphere and shows a particle size of 20-90 µm. The paste is made by refining this metallic powder.

When molten solder is extruded through microscopic nozzle holes of less than 100 µm in size, for example 18 µm, in an inert gas atmosphere, that molten solder forms extremely small long vertical conical shapes, continuously hanging from the nozzle holes, and at the tip of these continuous shapes, molten solder changes from droplet shapes to microscopic spherical shapes, of 44µm in size at that point, which continue falling and solidifying to form the desired powder. The molten solder (powder) in this spherical forms a non-oxidisable sphere, as internal oxidation is avoided through the cooling and solidifying of the outer layer. Examination and enlargement of this sphere (powder) under a microscope indicates that for some reason not entirely clear, part of the curved surface (the surface drawn in a smooth curve) has a non-curved surface part (non-smooth surface with a flat or ridged surface). Through the provision of this non-curved surface on part of the curved surface, the stability of the powder itself is increased, and when a solder paste made by kneading this powder into a flux is printed on, the solder does not "dull". Further a powder of uniform granularity, of a good size distribution and of the microscopic size desired can be obtained efficiently through the said processing i.e. the extrusion of molten metal, without interruption, from a large number of, say 40, nozzles. However, since the solder powder obtained as metallic powder is gained without forcible destruction, in other words without applying a forcible shock, "fine" does not occur and even if the powder is used as paste, solder balls do not occur after solder heating and melting (reflow).

Also, as a device for manufacturing the metallic powder described above, this invention presents a metallic powder manufacture device in which molten metal, under pressure of an inert gas atmosphere, is forced through nozzle holes in an extruding nozzle consisting of multiple nozzle holes, and made to flow, small droplets being made to fall from the tips of continuous vertical hanging parts, the shape of these microscopic droplets being altered from droplet shape to spherical shape as they fall through an atmosphere, and are cooled and solidify.

Further this invention presents as a metallic powder manufacture device, a device in which the arrangement of the nozzle holes and their size has been specially designed. Specifically, in the metallic powder manufacture device described above, the nozzle holes in the nozzle plate are arranged such that when the holes are larger than a constant value determined by the diameter of the nozzle holes, and further are arranged in lines from the circumference of the plate facing a central point, the distance between the holes is larger than the constant value determined by the size of the metallic powder to be manufactured; or the holes may be arranged in one straight line with the interval between the holes being larger than a constant value determined by the diameter of the nozzle holes. Furthermore, the size of the nozzle holes is preferably approximately one-third of the size of the metallic particles produced by said device.

As a result of the arrangement of the nozzle holes as described above, due to a phenomena not entirely understood but difficult to produce with any other arrangement, the random growth of powder by mutual clumping together of droplets as they fall can be prevented, giving a metallic powder which falls within a very narrow range of particle size distribution compared to prior art methods.
Fig. 1 is a partially cut-away side view of the powder,
Fig. 2 is a microscope photograph of the particles at 1000 times magnification showing that the powder has no fine, and part of the curved surface has a non-curved part,
Fig. 3 is a side view showing a chip mounted on the printed circuit board, using solder paste,
Fig. 4 is a microscope photograph of the particles at 150 times magnification showing powder of a uniform size, around 37-90 µm in diameter,
Fig. 5 is a microscope photograph at 200 times magnification showing that there is no conspicuous occurrence of solder balls after heating and melting (reflow) of the solder,
Fig. 6 is an overall side view of the device, partially cut-away to indicate the metallic powder manufacture device,
Fig. 7 is an enlarged side section view of the extruded nozzle area,
Fig. 8 is a partially cut-away outline side view of another embodiment of the "solder" powder manufacture device,
Fig. 9 shows a partial side sectional view of the bottom of the pressure vessel,
Fig. 10 is an overall perspective view of the nozzle plate,
Fig. 11 is an expanded sectional view of the nozzle holes,
Figs. 12 to 14 are outline plan views showing different arrangements of nozzle holes,
Fig. 15 is a microscope photograph of the particles at 100 times magnification,
Fig. 16 is a microscope photograph of the particles at 500 times magnification,
Fig. 17 is a partially cut-away outline side view showing another embodiment of the "solder" powder manufacture device,
Fig. 18 is a microscope photograph of the particles obtained using the previous atomization method, magnified 500 times, and
Fig. 19 is a microscope photograph of solder balls.

The embodiments of this invention will be described with reference to the drawings. In this description, "metallic powder" and "paste" have many of the same features so where necessary for the purposes of explanation, the metallic powder will be described as "solder powder", and the paste as "solder paste".

In the above and in the following descriptions, the term "powder" is used in the broad sense of the word, meaning both one particle and a collection of multiple particles.

First, the "solder powder" will be described.

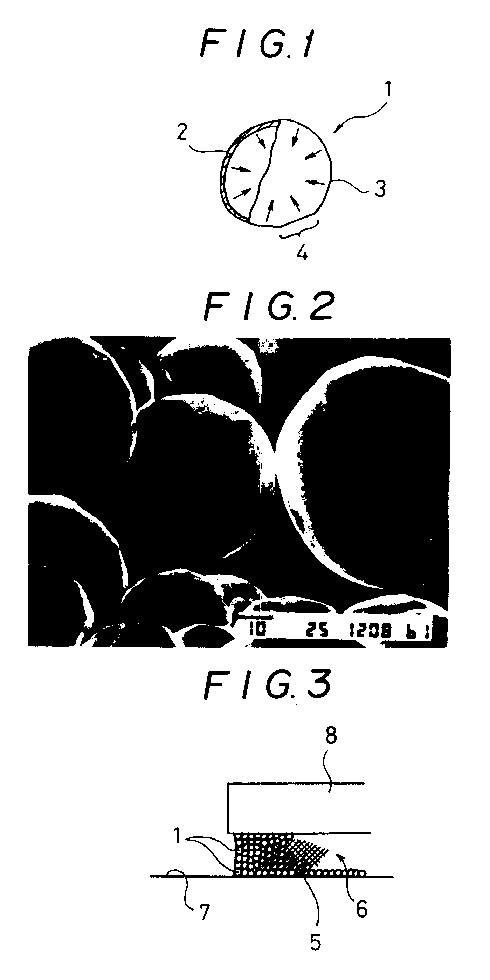

When molten solder is extruded through microscopic nozzle holes of less than 100 µm in size, for example 18 µm, in an inert gas atmosphere, that molten solder forms extremely small long vertical conical shapes, continuously hanging from the nozzle holes, and at the tip of these continuous shapes, molten solder changes from droplet shapes to microscopic spherical shapes, of 44µm in size at that point, which continue falling and solidifying to form the desired powder. As shown in Fig. 1, the molten solder (powder) 1 in this spherical shape forms a non-oxidisable sphere, as internal oxidation is avoided through the cooling and solidifying of the outer layer 2. Examination and enlargement of this sphere (powder) 1 under a microscope indicates that for some reason not entirely clear, part of the curved surface 3 (the surface drawn in a smooth curve) has a non-curved surface part 4 (non-smooth surface with a flat or ridged surface). Through the provision of this non-curved surface 4 on part of the curved surface 3, when a solder paste 6 made by kneading this powder 1 into a flux 5 is printed on a printed circuit board 7, the solder does not indicate "dulling" and further when a chip package 8 is placed on top (in Fig. 3), the fact that solder balls do not occur after solder heating and melting (reflow) can be verified.

The flux 5 includes flux for dissolving evenly such elements as rosin for purification of the metal surface and prevention of re-oxidation during heating; an activator for purification of the metal surface; and a viscosity agent for regulation of viscosity.

A powder 1 of the said content, and of the desired small size and uniformity, with an even size distribution, can be efficiently obtained from molten solder extruded from numerous microscopic nozzle holes. Further, the powder 1 thus obtained has no fine, and if kneaded into the said flux 5 and used as a paste 6, solder balls do not occur after reflow.

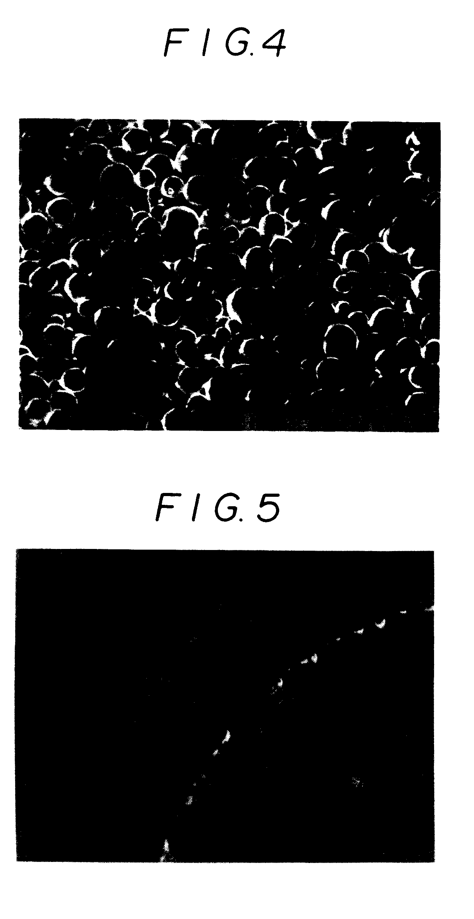

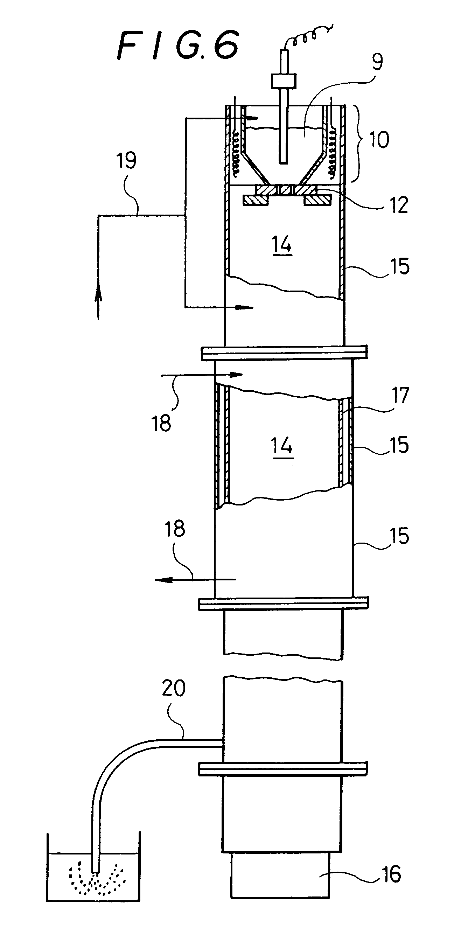

This situation is demonstrated in the microscope photographs. Fig. 2 demonstrates, at 1000 times magnification, that the powder 1 contains no fine, and that parts of the curved surface have non-curved surfaces. Fig. 4 is a photograph at 150 times magnification, with the powder obtained through sifting to the 37-90µm range being extremely evenly sized. Fig. 5 is a a photograph taken at 200 times magnification, indicating that solder balls do not occur after solder heating and melting (reflow).

The "metallic powder and paste made from it" of this invention, does not apply only to the solder powder and solder paste as described above, but may also apply to copper alloy powder and its copper paste, gold alloy paste and its gold wax, silver alloy powder and its silver wax, or zinc powder, indium alloy powder, and its paste. However, description of these additional types has been omitted in order to reduce redundancy.

Next, the metallic powder manufacture device will be described.

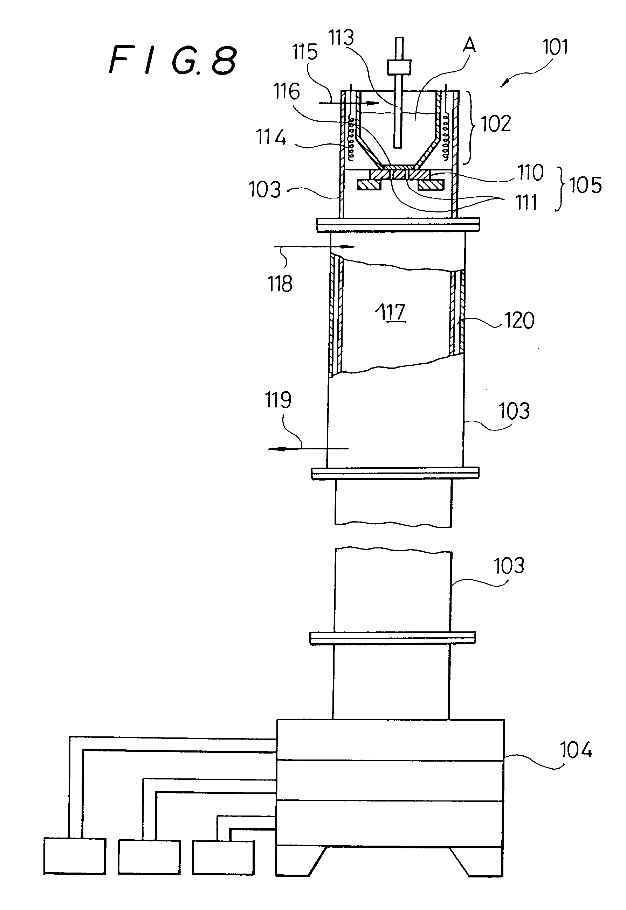

In describing the device used to obtain powder 1 with reference to the drawings Figs. 6 and 7, the device is constructed serially, from top to bottom, of a pressure vessel 10 used to contain the molten metal 9 and to heat it and maintain its temperature; an extrusion nozzle 12, provided with multiple microscopic nozzle holes 11 arranged at the bottom of the said pressure vessel 10; a case 15 with a processing space 14, on the exit side of the nozzle holes 11, and in which the molten metal 13 which is extruded from the nozzle holes 11 continuously falls and is cooled; and a powder extraction vessel 16 provided at the bottom of the case 15. Within the case 15 is provided a cooling jacket 17 as a cooling means, and a cooled water inlet and outlet 18, with the inert gas introduction means 19 connected to both the said pressure vessel 10 and the case 15, and the inert gas discharge means 20 connected at the bottom of the case 15.

The metallic powder and paste, along with the metal powder manufacture device, of this invention, as described above, have the following benefits.
a. Because parts of the curved surface of the powder are non-curved, the powder is internally stable and paste made using this powder will not "dull" after printing or painting.
b. The molten metal extruded from the nozzle holes of microscopic size, forms hanging continuous shapes, microscopic long vertical conical shapes, which change from droplet to spherical shape (powder), producing shapes microscopic in size.
c. The spherical molten metal becomes powder as designed as the microscopic spheres solidify while falling, and because the outer layer hardens through cooling processing, oxidation of the inside is prevented, and further since it does not oxidize, the paste made from the powder can be preserved for long periods, without deterioration in the solderability of the paste, making use very economical since the whole amount can be used until it runs out, there being no need to dispose of it in the meantime.
d. Through use of nozzle holes of different sizes, the size of the powder can be regulated easily, and powder of uniform size can be obtained in large amounts.
e. Where nozzle holes of around 18µm in size are used, the average size of the powder is 55-60µm, providing a very uniform powder without any fine.
f. Since an extremely evenly sized powder is obtained, solder paste made using this powder performs well in painting (printing) on printed circuit boards and is ideal for high-density (narrowly spaced) patterns.

Next, a second embodiment of this invention will be described with reference to Figs. 8 to 16.

In the above and following description the terms "metallic particle" and "particle" are used in the broad sense of the words, meaning both one particle and a collection of multiple particles i.e. a metallic powder.

Further in the description of this embodiment, the words "metallic powder" and "powder" are used interchangeably.

This embodiment involves a "solder" particle manufacture device 101 which is used to manufacture "solder" particles.

This "solder" particle manufacture device 101, as shown in Fig. 8, is constructed of a pressure vessel 102, a case 103 and a powder extractor 104, connected serially from top to bottom, with a nozzle plate 105 mounted at the bottom of the pressure vessel 102.

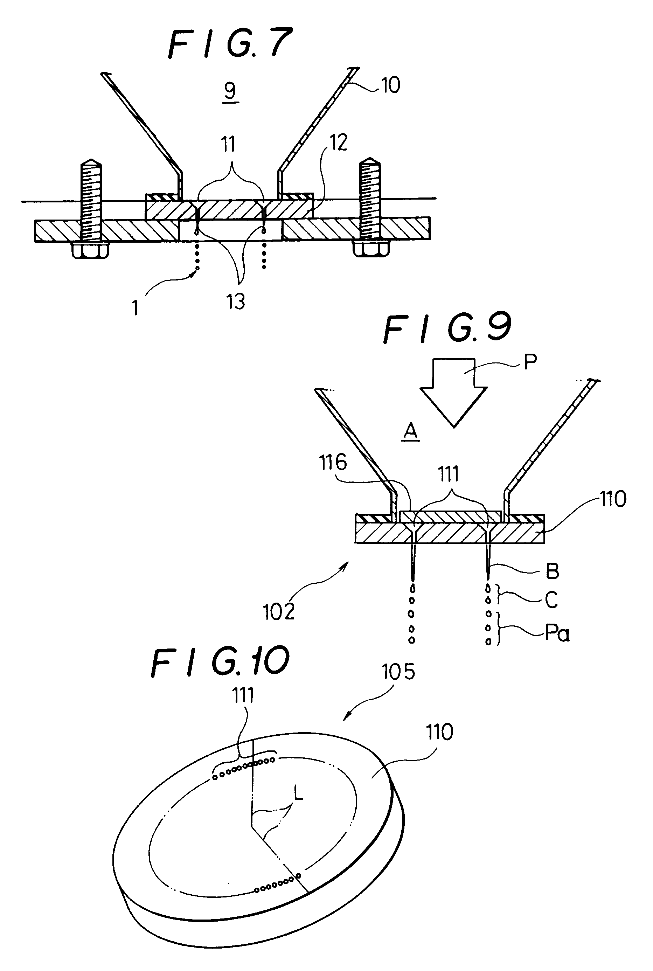

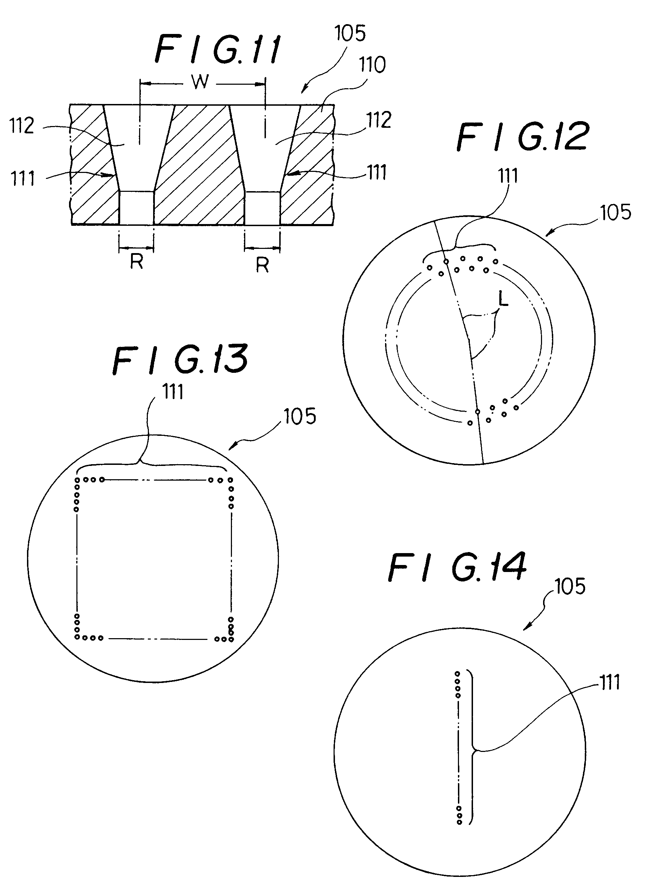

The nozzle plate 105 consists of a plate 110 pierced with multiple microscopic nozzle holes 111. The arrangement of these nozzle holes 111 is such that if the interval W between the nozzle holes 111 is larger than the constant value assigned in accordance with the diameter R of the nozzle holes 111, or more specifically is greater than R x 100, and the nozzle holes 111 are arranged in lines L facing a central point from the circumference of the plate 105, that interval is larger than the constant value determined by the correlation with the particle size of the metallic particles to be manufactured. In other words, in general, the sole condition for the arrangement of holes is that the distance between the holes is must be greater than the constant value determined by the diameter R of the nozzle hole 111. Where the holes are aligned along the lines L, the arrangement must be such that the holes are not positioned at intervals smaller than the fixed value determined by the correlation with the size of the metallic particles. Two specific examples of arrangements are the circular arrangement shown in Fig. 10 and the double circular arrangement shown in Fig. 12. These are the most advantageous arrangements both in order to prevent the random growth of the droplets C during their descent, as a result of mutual cohesion, but also from the point of view of maintaining at a uniform temperature, the respective molten solder A and molten solder B extruded from the nozzle holes 111. However, the square arrangement shown in Fig. 13 and a linear arrangement with the opposing two sides of the square removed, may also be used. The linear arrangement shown in Fig. 14 can also be employed since if only the condition determined by the diameter R of the said nozzle hole 111 is satisfied, the said condition determined by the correlation of the size of the metallic particles no longer applies. Further, each of the nozzle holes 111, as indicated in Fig. 11, is shaped with an upper tapered guide part 112. This tapered guide part 112 has the advantage of facilitating a smooth flow of solder A (described later). Experiments proved that the diameter R of the nozzle hole 111 is ideally approximately one-third of the size of the "solder" particle Pa. In this embodiment, the size of the nozzle hole was 18 µm, giving a solder particle Pa with an average diameter of approximately 55-65 µm.

The pressure vessel 102 contains molten solder A, and is used to heat it and maintain its temperature at approximately 250 degrees C. In the middle it has a thermo-couple 113 and on the periphery a band heater 114, with a nozzle plate 105 mounted at the bottom as described above. This pressure vessel 102 is sealed tightly, and connected to it there is an inert gas introduction means 115, such that an inert gas atmosphere is maintained inside the pressure vessel 102 and a certain pressure P can be applied to the molten solder A. 116 is a filter, which is mounted on the nozzle plate 105 in order to filter out oxidized particles of solids which are mixed in the molten solder A. The ideal materials for this filter 116 are glass fiber filter paper, silica fiber filter paper, or quartz fiber filter paper, which should be fire-resistant to more than 500 degrees C.

The case 103 is constructed of a processing space 117, divided into sections, and overall having a tubular shape. The case 103 is external to the nozzle plate 105, and is designed for the purpose of creating particles Pa from the molten solder A forcibly extruded in threads from the nozzle holes 111 on the nozzle plate 105 as a result of the pressure P; specifically by altering the overall shape of the droplets C which are dropped from the tip of the thread-shaped part B, from a droplet shape to a spherical shape as they cool while falling through the inert gas atmosphere and solidify into particles. The molten solder A falling continuously in threads from each of the nozzle holes 111 creates an effect like that of a shower. In the middle of case 103 a cooling jacket 120 connected to a cooled water inlet 118 and an outlet 119, constructed as a double wall, is provided. The height of case 103 influences the size of the processing space 117; an ideal height is such that the droplet C which falls from the tip of the thread-shaped molten solder B solidifies into the "solder" particle Pa as intended.

The powder extractor 104 is used to extract the particles Pa as powder while grading the particles Pa automatically according to their different size ranges. The powder extractor 104 is most desirably located at the bottom of the case 103.

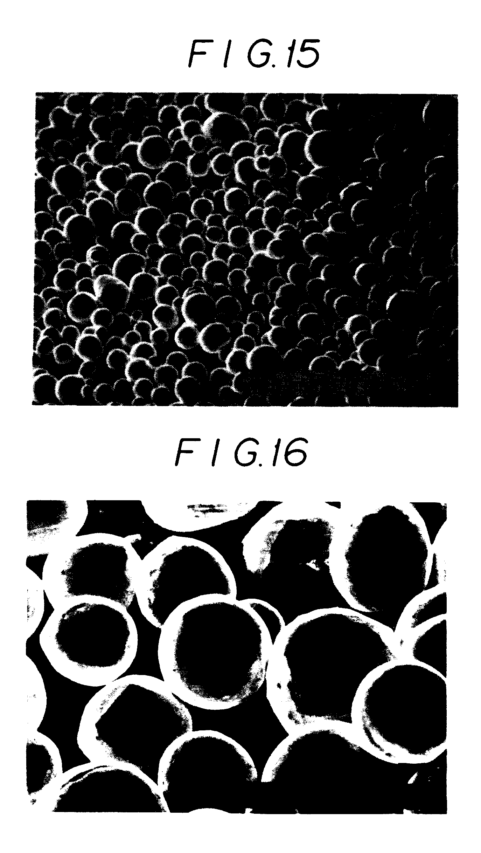

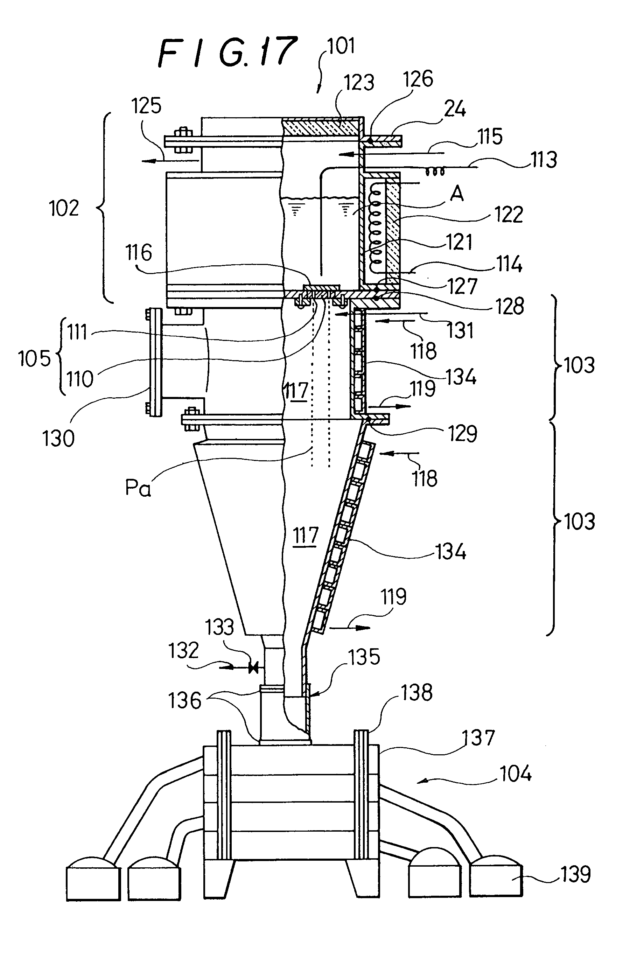

As described above, in this embodiment, molten solder A is forced out, under pressure, of microscopic nozzle holes approximately 18µm wide in thread-like shapes, a small droplet C falls from the tip of that thread-shape B, and while this droplet C is falling it changes overall shape from a droplet shape to a spherical shape as it cools and solidifies into "solder" particles Pa. The particles Pa thus formed do not form smaller than a certain size, as small as "fine" for example, and at the same time, as a result of the arrangement of the nozzle holes 111 as described above, the random growth of particles through coagulation during the descent of droplets C is prevented, although it is not clear through which phenomena; suffice that this is difficult to achieve with any other arrangement. As a result, in contrast to the particles sizes obtained through former methods, which gave an R-R distribution (or Rosin - Rammer distribution) where n = 1 approximately, is is now possible to obtain a powder of "solder" particles Pa with an particle size distribution in the extremely narrow range of n=6-8. Fig. 15 shows a photograph at 100 times magnification, indicating the uniformity of particle size. Fig. 16 shows a 500 times magnification, clearly demonstrating that the powder contains no "fine".

Next, another embodiment of the "solder" particle manufacture device will be described with reference to Fig. 17. This embodiment has many features in common with the previous embodiment described in Figs. 8 - 16; these common parts have been given the same symbols as in the previous embodiment and redundant description has been omitted.

### Pressure vessel 102

Pressure vessel 102 has a band heater 114 arranged on the outside of the furnace 121, the heater 114 being is further covered by non-flammable material 122. At the top opening of the furnace 121 is a furnace cover 124 made of non-flammable material, and in the closed internal space, inert gas is forcibly introduced through the inert gas introduction means 115, so that pressure P is applied to the molten solder A. Any excess inert gas is discharged to the outside of the pressure vessel 102 from the discharge regulation means 125. 126 is an O ring, a seal against pressure. 127, 128 and 129 are also respective O rings, as shown.

### Nozzle plate 105

Nozzle holes 111 corresponding to the double circular arrangement shown in Fig. 12 are constructed in the plate 110, the plate 110 being part of the bottom section.

### Case 103

The height of the processing space 117 has been designed as small as possible. Both the upper case 103 which directly supports the pressure vessel 102, and the lower case 103 which supports the said upper case 103 are low in height. 130 is an observation hole, set on the side of the upper case 103, designed to permit direct observation from the outside, of the inside of the processing space 117. An inert gas introduction means 131 is constructed on the upper part of the upper case 103, while a discharge means 132 is constructed on the lower part of the lower case 103, so that the processing space 117 has the same inert atmosphere as in the pressure vessel 102. The discharge means 132 is provided with an outflow prevention valve 133 so that oxygen cannot enter the inside of the vessel. 134 is a cooling coil which covers the external surface of both the upper and lower case 103, said cooling coil 134 being connected to a cooled water inlet 118 and a cooled water outlet 119.

The lower case 103 has an inverse conical shape and acts also as a collection tube for the "solder" particles Pa.

### Powder extractor 104

The bottom of the lower case 103 is connected to multiple gyro sifters 137 via a flexible rubber tube 135 and a hose band 136. In the example shown in the drawing, the gyro sifters 137 are constructed in layers, one sifter for each of the four size ranges of particles, and also supported by an elastic bendable supporting member 138 so that all the gyro sifters 137 vibrate freely. Each of the gyro sifters 137 is attached to its own individual vessel 139, so that the "solder" particles Pa sifted through the gyro sifters 137 are extracted automatically via vibration and collected in the vessels 139.

According to the metallic particle manufacture device of this invention, through its construction as explained above, molten metal can be pressed through and made to flow out of microscopic nozzle holes in threads, so that tiny droplets fall from the tips of these threads, these small droplets changing their whole shape from droplet shape to spherical shape as they cool and solidify while falling; with regard to the size of the metallic particles thus formed, the occurrence of particles below a certain size, particularly "fine", is avoided, and further because the arrangement of nozzle holes is also fixed, the random growth of particles by clumping together while falling is prevented, due to a phenomena not entirely understood but extremely difficult to produce with any other arrangement; through these means it is possible to obtain a powder made of metallic particles within a narrow particle size distribution range compared with prior art methods.

This invention permits the acquisition of a metallic powder microscopic in size of between 20 and 90 µm through a process in which molten metal is extruded from many microscopic nozzle holes, the droplets being altered to spherical shapes as they fall while solidifying, such metallic powder having non-curved surfaces in parts of the curved surface of the sphere; this metallic powder being ideal as a metallic powder for solder.

## Claims

1. A metallic powder obtainable by extrusion of molten metal from multiple microscopic nozzle holes in an inert gas atmosphere, cooled while falling, and during that cooling changing its overall shape from droplet shape to spherical shape and hardening, said metallic powder having non-curved sections in parts of the generally curved surface forming the sphere and shows a particle size of 20-90 µm.

2. A metallic powder according to Claim 1, wherein the molten metal is molten solder and the metallic powder is solder powder.

3. A metallic powder according to Claim 2, wherein the solder powder is used for a solder paste which is made by kneading the solder powder into flux.

4. A metallic powder according to Claim 1, wherein the molten metal is either molten copper alloy, molten gold alloy or molten silver alloy, and the metallic powder is copper alloy powder, gold alloy powder or silver alloy powder.

5. A metallic powder according to Claim 4, wherein the powder is used for a paste or wax made by kneading said powders.

6. A metallic particle manufacture device constructed serially from top to bottom of:
a pressure vessel provided at least with a furnace containing molten metal, with a nozzle plate furnished with nozzle holes and formed at the bottom of the furnace, and a means of introducing inert gas into the furnace;
a case provided with at least an introduction means and a discharge regulation means for introducing inert gas to the internal processing space and discharging it, the lower part of the case body shaped in an inverse conical shape; and
a cooling means covering the exterior surface; and
a collection of multiple gyro sifters for classifying and sorting the metallic particles showing a size of 20-90 µm in accordance with the particle size ranges.

7. A device according to Claim 6, wherein the size of the nozzle holes is approximately one-third of the size of the metallic particles produced by said device.

8. A device according to Claim 6, wherein the distance between the nozzle holes is greater than a constant value determined by the diameter of the nozzle holes.

9. A device according to Claim 6 or 8, wherein the nozzle holes of the nozzle plate are arranged in straight lines.

10. A device according to Claim 6 or Claim 8, wherein the nozzle holes of the nozzle plate are arranged in one circle.

11. A device according to Claim 6 or Claim 8, wherein the nozzle holes of the nozzle plate are arranged in two circles, and not so that the nozzle holes in these circles are arranged in lines extending from the circumference towards a central point.

12. A process for producing a metallic powder according to Claim 1, wherein a molten metal, under continuous pressure of an inert gas atmosphere, is forced through nozzle holes in an extrusion nozzle provided with multiple nozzle holes, microscopic droplets being made to fall from the tips of the continuous hanging shapes, the shape of said droplets being altered from droplet shape to generally spherical shape as they cool and solidify while falling continuously at the atmospheric pressure created by the inert gas.

## Patentansprüche

1. Metallpulver, erhältlich mittels Extrusion geschmolzenen Metalls aus einer Vielzahl mikroskopischer Düsen-Öffnungen in einer Inertgasatmosphäre, wobei während des Fallens eine Abkühlung erfolgt und während der Abkühlung sich seine gesamte Form von einer Tröpfchenform zu einer runden Form hin verändert und eine Erstarrung erfolgt, und wobei das Metallpulver nicht-gekrümmte Bereiche auf Teilen der allgemein gekrümmten, die Kugel bildenden Oberfläche aufweist und eine Teichengröße von 20 - 90 µm zeigt.

2. Metallpulver nach Anspruch 1, wobei das geschmolzene Metall geschmolzenes Lot und das Metallpulver Lötpulver ist.

3. Metallpulver nach Anspruch 2, wobei das Lötpulver für eine Lötpaste verwendet wird, die durch Kneten des Lötpulvers in ein Flußmittel hergestellt wird.

4. Metallpulver nach Anspruch 1, wobei das geschmolzene Metall entweder aus geschmolzener Kupferlegierung, geschmolzener Goldlegierung oder geschmolzener Silberlegierung besteht, und wobei das Metallpulver aus Pulver aus Kupfer-, Gold- oder Silberlegierung besteht.

5. Metallpulver nach Anspruch 4, wobei das Pulver für eine Paste oder ein Wachs, hergestellt mittels Knetens des Pulvers, verwendet wird.

6. Vorrichtung zur Herstellung von Metallteilchen, vom oberen Ende bis zum unteren Ende aufeinanderfolgend gefertigt aus:
einem Druckbehälter, versehen mit mindestens einem Schmelzofen, der das geschmolzene Metall enthält, und mit einer Düsenplatte, versehen mit Düsen-Öffnungen und gebildet am unteren Ende des Schmelzofens, und einer Einrichtung zum Einleiten eines Inertgases in den Schmelzofen;
einem Gehäuse, versehen mit mindestens einer Einlaßeinrichtung und einer Einrichtung zur Regulierung des Auslasses, um das Inertgas in den inneren Verarbeitungsraum einzuleiten und um es austreten zu lassen, wobei der der untere Teil des Gehäusekörpers zu einer inversen konischen Form geformt ist;
einer Abkühleinrichtung, die die Außenfläche bedeckt;
und einer Ansammlung Mehrfachkreiselsiebe zur Klassierung und Sortierung der Metallteilchen, die in Übereinstimmung mit den Teilchengrößenbereichen eine Größe von 20 bis 90 µm zeigen.

7. Vorrichtung nach Anspruch 6, wobei die Größe der Düsen-Öffnungen angenähert ein Drittel der Größe der durch die Vorrichtung hergestellten Metallteilchen beträgt.

8. Vorrichtung nach Anspruch 6, wobei der Abstand zwischen den Düsen-Öffnungen größer als ein konstanter Wert, festgelegt durch den Durchmesser der Düsen-Öffnungen, ist.

9. Vorrichtung nach Anspruch 6 oder 8, wobei die Düsen-Öffnungen der Düsenplatte in geraden Linien angeordnet sind.

10. Vorrichtung nach Anspruch 6 oder 8, wobei die Düsen-Öffnungen der Düsenplatte zu einem Kreis angeordnet sind.

11. Vorrichtung nach Anspruch 6 oder 8, wobei die Düsen-Öffnungen der Düsenplatte zu zwei Kreisen angeordnet sind, aber nicht so, daß die Düsen-Öffnungen in diesen Kreisen in Linien angeordnet sind, die sich von der Kreislinie hin zu einem zentralen Punkt erstrecken.

12. Verfahren zur Herstellung eines Metallpulvers nach Anspruch 1, wobei ein geschmolzenes Metall unter dem kontinuierlichen Druck einer Inertgasatmosphäre durch Düsen-Öffnungen einer mit einer Vielzahl Düsen-Öffnungen versehenen Extrusions-Düse gezwungen wird, unter Bildung mikroskopischer Tropfen, die von den Spitzen der kontinuierlich herabhängenden Formen abfallen, wobei sich die Form der Tröpfchen während ihres kontinuierlichen Falls unter atmosphärischen Drucks, verursacht von dem Inertgas, unter Abkühlung und Verfestigung von einer Tröpfchenform hin zu einer allgemein runden Form verändert.

## Revendications

1. Poudre métallique susceptible d'être obtenue par extrusion de métal fondu, à partir d'une pluralité de trous de buse microscopiques, dans une atmosphère de gaz inerte, accompagnée d'un refroidissement pendant la descente, et où, pendant ce refroidissement se produit le changement de sa forme générale, qui passe d'une forme en gouttelette à une forme sphérique, puis durcissement, ladite poudre métallique ayant des sections non incurvées dans des parties de la surface généralement incurvé formant la sphère et présentant une taille de particule allant de 20 à 90 µm.

2. Poudre métallique selon la revendication 1, dans laquelle le métal fondu est de la soudure fondue et la poudre métallique est de la poudre de soudure.

3. Poudre métallique selon la revendication 2, dans laquelle la poudre de soudure est utilisée pour donner une pâte de soudure, obtenue en pétrissant la poudre de soudure pour obtenir un flux.

4. Poudre métallique selon la revendication 1, dans laquelle le métal fondu est soit un alliage de cuivre fondu, un alliage d'or fondu, soit un alliage d'argent fondu, et la poudre métallique est une poudre d'alliage de cuivre, une poudre d'alliage d'or, ou une poudre d'alliage d'argent.

5. Poudre métallique selon la revendication 4, dans laquelle la poudre est utilisée pour donner une pâte ou cire, produite par pétrissage desdites poudres.

6. Dispositif de préparation de particules métalliques construit en mettant en série, en partant du haut vers le bas :
un récipient à pression, prévu au moins avec un four contenant du métal fondu, avec une plaque de buses équipée de trous de buse et formée en partie inférieure du four, et un moyen pour introduire du gaz inerte dans le four ;
un carter, pourvu d'au moins un moyen d'introduction et un moyen de régulation d'évacuation, pour introduire du gaz inerte dans l'espace de traitement interne et l'évacuer, le partie inférieure du corps de carter ayant la forme d'un cône inversé ; et un moyen de refroidissement, recouvrant la surface extérieure ; et une pluralité de tamis tournants, pour classer et trier les particules métalliques présentant une taille comprise dans la plage allant de 20 à 90 µm, selon la granulométrie des particules.

7. Dispositif selon la revendication 6, dans lequel la taille des trous de buses est d'approximativement d'un tiers de la taille des particules métalliques produites par ledit dispositif.

8. Dispositif selon la revendication 6, dans lequel la distance entre les trous de buse est supérieure à une valeur constante déterminée par le diamètre des trous de buses.

9. Dispositif selon la revendication 6 ou 8, dans lequel les trous de buses de la plaque à buses sont agencés en lignes droites.

10. Dispositif selon la revendication 6 ou 8, dans lequel les trous de buses de la plaque à buses sont agencés sur un cercle.

11. Dispositif selon la revendication 6 ou 8, dans lequel les trous de buses de la plaque à buses sont agencés sur deux cercles, ceci en évitant que les trous de buse situés sur ces cercles se trouvent placés sur des lignes allant de la circonférence vers un point central.

12. Procédé d'une préparation d'une poudre métallique selon la revendication 1, dans lequel un métal fondu, placé sous une pression continue d'une atmosphère d'un gaz inerte, est passé, de façon forcée, à travers des trous de buse, dans une buse d'extrusion équipée d'une pluralité de trous de buse, en formant des goutelettes microscopiques accrochés aux bouts des filets sortant de façon continue, la forme des dites gouttelettes étant modifiée pour passer d'une forme de gouttelette à une forme généralement sphérique, lorsqu'elles se refroidissent et se solidifient toutes en tombant, de façon continue, à la pression atmosphérique crée par le gaz inerte.
